# EUROPÄISCHE PATENTANMELDUNG

(11) **EP 4 741 924 A1**
(43) Veröffentlichungstag der Anmeldung: **13.05.2026**
(21) Anmeldenummer: 24212375.0
(22) Anmeldetag: 12.11.2024
(51) Int. Cl.: G03F 7/00, B82Y 40/00

(54) **ANORDNUNG UND VERFAHREN ZUM LOKALISIERTEN AUFBRINGEN VON MOLEKÜLEN AUF EINEM TRÄGER**

(71) Anmelder: Technische Universität Berlin, 10623 Berlin (DE)
(72) Erfinder: FRANZ, Martin, 13597 Berlin (DE); KUBICKI, Milan, 12049 Berlin (DE); SCHMIDT, Dominik, 14532 Stahnsdorf (DE)
(74) Vertreter: Fischer, Uwe

(57) **Zusammenfassung**

Die Erfindung bezieht sich unter anderem auf ein Verfahren zum lokalisierten Aufbringen von Molekülen (M) auf einem Träger (20), bei dem unter Vakuumbedingungen auf dem Träger (20) eine die Moleküle (M) enthaltende, zweidimensionale Monolagengasschicht (MGS) gebildet wird, in der sich die zu der zweidimensionalen Monolagengasschicht (MGS) gehörenden Moleküle (M) parallel zur Oberfläche (21) des Trägers (20) bewegen können, und durch Anlegen einer elektrischen Spannung (U) zwischen dem Träger (20) und einer unmittelbar oberhalb des Trägers (20) und mit der zweidimensionalen Monolagengasschicht (MGS) interagierenden Nadelspitze (12) die in der Nähe der Nadelspitze (12) befindlichen Moleküle (M) der zweidimensionalen Monolagengasschicht (MGS) auf dem Träger (20) gezielt dauerhaft lokalisiert werden.

## Beschreibung

Die Erfindung bezieht sich auf Anordnungen und Verfahren zum lokalisierten Aufbringen von Molekülen auf einem Träger.

Es sind bereits verschiedene Verfahren bekannt, bei denen Rastersondenmikroskopieverfahren genutzt werden, um gezielt Nanostrukturen auf Oberflächen herzustellen. Diese lassen sich unter dem Begriff Rastersondenlithografie (englisch *scanning probe lithography,* SPL) zusammenfassen. Dabei werden unterschiedliche physikalische und chemische Effekte zur lokalen Veränderung der Struktur der Probenoberfläche unterhalb einer räumlich positionierbaren Spitze genutzt. Beispiele sind thermische bzw. thermochemische SPL, wobei eine geheizte Spitze zur Strukturierung der Oberfläche verwendet wird, oder Oxidations-SPL, wobei die Bildung einer Wasserbrücke zwischen Spitze und Probe zu einer lokalen Oxidation der Oberfläche führt. Die verschiedenen Methoden sind beispielsweise in den in der unten beigefügten Literaturliste aufgeführten Artikeln [1] und [2] beschrieben.

Der Erfindung liegt die Aufgabe zugrunde, ein Verfahren anzugeben, mit dem sich eine strukturierte Molekülmonolagenschicht mit geringem Aufwand herstellen lässt.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß ein Verfahren zum lokalisierten Aufbringen von Molekülen auf einem Träger vorgesehen, bei dem unter Vakuumbedingungen auf dem Träger eine die Moleküle enthaltende, zweidimensionale Monolagengasschicht gebildet wird, in der sich die zu der zweidimensionalen Monolagengasschicht gehörenden Moleküle parallel zur Oberfläche des Trägers bewegen können, und durch Anlegen einer elektrischen Spannung zwischen dem Träger und einer unmittelbar oberhalb des Trägers und mit der zweidimensionalen Monolagengasschicht interagierenden Nadelspitze die in der Nähe der Nadelspitze befindlichen Moleküle der zweidimensionalen Monolagengasschicht auf dem Träger gezielt dauerhaft lokalisiert werden.

Ein wesentlicher Vorteil des erfindungsgemäßen Verfahrens besteht darin, dass durch das gezielte Lokalisieren von Molekülen der Monolagengasschicht Muster geschrieben werden können, bei denen die mit den Molekülen geschriebenen Bereiche jeweils nur aus einer Molekülmonolage bestehen.

Ein weiterer wesentlicher Vorteil des erfindungsgemäßen Verfahrens besteht darin, dass dieses mit verhältnismäßig geringen elektrischen Spannungen und damit im Vergleich zu anderen Beschichtungsverfahren verschleiß- bzw. zerstörungsfrei, zumindest vergleichsweise verschleiß- bzw. zerstörungsarm, durchgeführt werden kann.

Vorteilhaft ist es, wenn ein Musterschreibprozess durchgeführt wird, bei dem auf dem Träger ein Muster bzw. Molekülmonolagenmuster mit lokalisierten Molekülen geschrieben wird, wobei die Polarität der Spannung zwischen Träger und Spitze während des Musterschreibprozesses invertiert wird. Ein solches Invertieren der Spannung erlaubt es beispielsweise, während des Nichtschreibens bzw. Nichtlokalisierens der Moleküle mit der Nadelspitze zu Messzwecken mittels der invertierten Spannung ein Abtasten des Trägers durchzuführen, beispielsweise, wenn das Verfahren mit der Nadelspitze eines Rastertunnelmikroskops durchgeführt wird. Im letztgenannten Falle kann während des Nichtschreibens bzw. Nichtlokalisierens der Moleküle zum Abtasten der Tunnelstrom ausgewertet werden; während des Schreibvorgangs ist der Tunnelstrom in der Regel für eine messtechnische Auswertung wegen der zeitlich parallelen Moleküllokalisierung zu rauschbehaftet.

Alternativ kann auch vorgesehen sein, dass außerhalb von Schreibabschnitten, also in Trennabschnitten ohne gewünschte Lokalisierung von Molekülen, die Nadelspitze mit einer Spannung von Null oder einer anderen zum Lokalisieren ungeeigneten Spannung über den Träger geführt wird. Das beschriebene Abtasten der Oberfläche des Trägers in Phasen, in denen keine Lokalisierung der Moleküle erfolgt, ist bei einer Spannung von Null zumindest bei Einsatz eines Rastertunnelmikroskops jedoch in der Regel nicht möglich.

Bei einer vorteilhaften Ausgestaltung ist vorgesehen, dass ein Musterschreibprozess durchgeführt wird, bei dem ein Muster bzw. Molekülmonolagenmuster mit zumindest einem Schreibabschnitt mit lokalisierten Molekülen geschrieben wird, indem in dem Schreibabschnitt die Nadelspitze mit einer ersten Spannungspolarität über den Träger geführt wird und außerhalb des Schreibabschnitts die Nadelspitze mit einer zweiten Spannungspolarität, die zu der ersten Spannungspolarität entgegengesetzt ist, über den Träger geführt wird.

Auch kann ein Musterschreibprozess vorgesehen sein, bei dem ein Muster bzw. Molekülmonolagenmuster mit zumindest zwei voneinander durch einen Trennabschnitt getrennten Schreibabschnitten mit lokalisierten Molekülen geschrieben wird, indem in den Schreibabschnitten die Nadelspitze mit der ersten Spannungspolarität über den Träger geführt wird und im Trennbereich zwischen den Schreibabschnitten die Nadelspitze mit der zweiten Spannungspolarität über den Träger geführt wird.

Besonders vorteilhaft ist es, wenn zwei oder mehr Musterschreibprozesse durchgeführt werden, wobei im Rahmen eines ersten Musterschreibprozesses ein zumindest einen Schreibabschnitt aufweisendes erstes Molekülmonolagenmuster mit einer ersten Molekülart geschrieben wird und im Rahmen eines zweiten Musterschreibprozesses ein zumindest einen Schreibabschnitt aufweisendes zweites Molekülmonolagenmuster mit einer zweiten Molekülart geschrieben wird.

Der oder die Schreibabschnitte des ersten Molekülmonolagenmusters sind vorzugsweise mit dem oder den Schreibabschnitten des zweiten Molekülmonolagenmusters überschneidungs- bzw. überlappungsfrei.

Der zweite Musterschreibprozess wird vorzugsweise erst durchgeführt, nachdem der erste Musterschreibprozess beendet wurde und die die erste Molekülart aufweisende zweidimensionale Monolagengasschicht den Träger verlassen hat, beispielsweise durch Abdampfen der Moleküle dieser ersten Molekülart. Die erste und zweite Molekülart können zum Beispiel jeweils unterschiedliche Arten an N-heterozyklischen Carben-(NHC)-Molekülen sein.

Die Spannung zwischen Träger und Spitze ist bei der ersten Spannungspolarität vorzugsweise eine positive Spannung, bei der das elektrische Potential an dem Träger höher als das elektrische Potential an der Spitze ist, und bei der zweiten Spannungspolarität demgemäß eine negative Spannung, bei der das elektrische Potential an dem Träger kleiner als das elektrische Potential an der Spitze ist.

Die Spannung zwischen Träger und Spitze liegt beim Schreiben der Schreibabschnitte vorzugsweise zwischen 2 und 5 Volt.

Vorteilhaft ist es, wenn die Moleküle durch Erhitzen eines die Moleküle enthaltenen Basismaterials bereitgestellt werden.

Bei einer besonders bevorzugten Ausgestaltung des Verfahrens ist vorgesehen, dass sich die Moleküle mit dem Träger unter Bildung der zweidimensionalen Monolagengasschicht koppeln und die zweidimensionale Monolagengasschicht auf der Trägeroberfläche durch eine durch die gekoppelten Moleküle bewirkte Haltekraft gehalten wird, wobei jedes der zu der zweidimensionalen Monolagengasschicht gehörenden Moleküle zu jedem Zeitpunkt jeweils mit mindestens einem Trägeratom an der Oberfläche des Trägers kraftmäßig gekoppelt ist.

Mit Blick auf das Lokalisieren der Moleküle wird es als vorteilhaft angesehen, wenn die Moleküle eine Ringstruktur aufweisen, alle zu der zweidimensionalen Monolagengasschicht gehörenden beweglichen Moleküle derart ausgerichtet sind, dass die Ringfläche ihrer Ringstruktur parallel zur Trägeroberfläche und der Bewegungsebene der Monolagengasschicht liegt, und durch das Anlegen der elektrischen Spannung zwischen dem Träger und der Nadelspitze die Ringstruktur der im Bereich der Nadelspitze befindlichen Moleküle aus der Ebene der Monolagengasschicht herausgedreht und dadurch auf dem Träger immobilisiert und fixiert wird. Das Herausdrehen erfolgt vorzugsweise um einen Winkel von 90°.

Bei einer als vorteilhaft angesehenen Ausführungsvariante ist vorgesehen, dass die Moleküle durch Erhitzen eines die Moleküle enthaltenen Basismaterials bereitgestellt werden, wobei das Erhitzen des Basismaterials in einem Effusionsraum während einer ersten zeitlichen Prozessphase erfolgt und mit Abschluss der ersten Prozessphase beendet wird, und wobei während dieser ersten Prozessphase in dem Effusionsraum eine dreidimensionale, die verdampften Moleküle enthaltende Gasatmosphäre erzeugt wird, aus der heraus sich alle oder zumindest ein Teil der Moleküle der Gasatmosphäre auf dem Träger unter Bildung der Monolagengasschicht abscheiden. Nach Abschluss der ersten Prozessphase wird der Träger in einer anschließenden zweiten Prozessphase vorzugsweise gemeinsam mit der darauf befindlichen Monolagengasschicht von dem Effusionsraum in einen ebenfalls unter Vakuumbedingungen befindlichen benachbarten Prozessraum, in dem sich die Nadelspitze befindet, überführt und das lokale Fixieren der Moleküle der Monolagengasschicht wird vorzugsweise in dem benachbarten Prozessraum durchgeführt. In der zweiten Prozessphase werden durch das Anlegen der elektrischen Spannung zwischen dem Träger und der Nadelspitze vorzugsweise in dem benachbarten Prozessraum die in der Nähe der Nadelspitze befindlichen Moleküle der zweidimensionalen Monolagengasschicht auf dem Träger dauerhaft lokalisiert.

Bei einer anderen als vorteilhaft angesehenen Ausführungsvariante ist vorgesehen, dass das lokale Fixieren der Moleküle der Monolagengasschicht in demselben Prozessraum durchgeführt wird, in dem auch die Moleküle in Form der Monolagengasschicht auf dem Träger abgeschieden werden. Während eines Erhitzens des Basismaterials wird in dem Prozessraum vorzugsweise eine dreidimensionale, die verdampften Moleküle enthaltende Gasatmosphäre erzeugt, aus der heraus sich alle oder zumindest ein Teil der Moleküle der Gasatmosphäre auf dem Träger unter Bildung der Monolagengasschicht abscheiden, wobei bereits während des Erhitzens oder nach dem Erhitzen durch das Anlegen der elektrischen Spannung zwischen dem Träger und der Nadelspitze die in der Nähe der Nadelspitze befindlichen Moleküle der zweidimensionalen Monolagengasschicht auf dem Träger dauerhaft lokalisiert werden.

Die mit der zweidimensionalen Monolagengasschicht interagierende Nadelspitze bildet vorzugsweise einen Bestandteil eines Rastertunnel- oder Rasterkraftmikroskops.

Die Moleküle sind vorzugsweise N-heterozyklische Carben-(NHC)-Moleküle. Vorzugsweise wird also eine strukturierte Monolagenschicht aus NHC-Material geschrieben.

Vorteilhaft ist es, wenn der Träger zumindest an der mit der zweidimensionalen Monolagengasschicht befindlichen Oberfläche aus dotiertem (vorzugsweise Bor-dotiertem) Silizium oder GaAs besteht.

Die Erfindung bezieht sich außerdem auf eine zum Aufbringen von Molekülen auf einem Träger geeignete Anordnung mit einer Effusionszelle zum Erhitzen eines die Moleküle enthaltenden Basismaterials unter Vakuumbedingungen und Bilden einer die Moleküle enthaltenden, zweidimensionalen Monolagengasschicht, in der sich die zu der zweidimensionalen Monolagengasschicht gehörenden Moleküle parallel zur Oberfläche des Trägers bewegen können, einer unmittelbar oberhalb des Trägers befindlichen und mit der zweidimensionalen Monolagengasschicht interagierenden Nadelspitze, einer Spannungsquelle zum Anlegen einer elektrischen Spannung zwischen dem Träger und der Nadelspitze, einer Nadelverstelleinrichtung und einer Steuereinrichtung, die dazu ausgestaltet ist, einen Musterschreibprozess zu steuern, und zwar durch Ansteuern der Nadelverstelleinrichtung und der Spannungsquelle und einem lokalen Hervorrufen einer Schreibspannung, die zum gezielten dauerhaften Lokalisieren der in der Nähe der Nadelspitze befindlichen Moleküle der zweidimensionalen Monolagengasschicht auf dem Träger führt.

Die Effusionszelle und die Nadelspitze sind bei einer bevorzugten Ausgestaltung innerhalb derselben Prozesskammer eines Rastertunnel- oder Rasterkraftmikroskops angeordnet.

Bei einer anderen bevorzugten Ausgestaltung ist die Effusionszelle in einer Effusionskammer neben einer Prozesskammer eines Rastertunnel- oder Rasterkraftmikroskops angeordnet und der mit der zweidimensionalen Monolagengasschicht beschichtete Träger kann unter Vakuumbedingungen von der Effusionskammer in die die Nadelspitze enthaltende Prozesskammer überführt werden.

Die Erfindung wird nachfolgend anhand von Ausführungsbeispielen näher erläutert; dabei zeigen beispielhaft:
- Fig. 1: ein erstes Ausführungsbeispiel für eine erfindungsgemäße Anordnung, die zur Durchführung erfindungsgemäßer Verfahren geeignet ist,
- Fig. 2: ein zweites Ausführungsbeispiel für eine erfindungsgemäße Anordnung, die zur Durchführung erfindungsgemäßer Verfahren geeignet ist,
- Fig. 3: ein Muster, das mit dem beschriebenen Verfahren geschrieben wurde,
- Fig. 4: ein NHC-Molekül auf einer Bor-dotierten Siliziumoberfläche, und
- Fig. 5: einen Testschreibvorgang zur Verifizierung der Arbeitsweise des Schreibverfahrens.

In den Figuren werden der Übersicht halber für identische oder vergleichbare Komponenten stets dieselben Bezugszeichen verwendet.

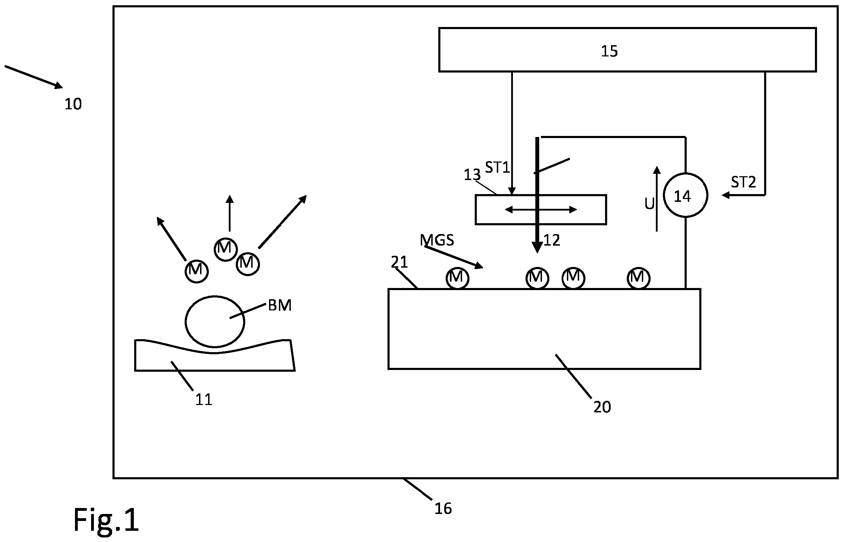

Die Figur 1 zeigt ein erstes Ausführungsbeispiel für eine erfindungsgemäße Anordnung 10, die zur Durchführung erfindungsgemäßer Verfahren geeignet ist.

Die Anordnung 10 umfasst eine Effusionszelle 11 zum Erhitzen eines die Moleküle M enthaltenden Basismaterials BM unter Vakuumbedingungen. Durch das Erhitzen werden Moleküle M des Basismaterials BM freigesetzt, von denen sich einige an der Oberfläche 21 eines Trägers 20 in Form einer zweidimensionalen Monolagengasschicht MGS ankoppeln. In dieser zweidimensionalen Monolagengasschicht MGS können sich die Moleküle M auf dem Träger 20 frei parallel zur Oberfläche 21 des Trägers 20 bewegen, bleiben dabei aber mit der Oberfläche 21 jeweils individuell gekoppelt.

Die Anordnung 10 umfasst außerdem eine unmittelbar oberhalb des Trägers 20 befindliche Nadel mit einer Nadelspitze 12, die aufgrund ihres geringen Abstands zur Oberfläche 21 mit der zweidimensionalen Monolagengasschicht MGS interagieren kann und Moleküle M im Bereich der Nadelspitze 12 auf dem Träger 20 dauerhaft lokalisieren bzw. anheften kann, sofern zwischen dem Träger 20 und der Nadelspitze 12 eine geeignete elektrische Spannung U anliegt.

Um ein solches Lokalisieren der Moleküle M gezielt an ausgewählten Orten der Oberfläche 21 des Trägers 20 zu ermöglichen, sind eine Nadelverfahreinrichtung 13, mit der sich die Position der Nadelspitze 12 relativ zum Träger 20 verstellen lässt, sowie eine Spannungsquelle 14 zum Anlegen einer elektrischen Spannung U zwischen dem Träger 20 und der Nadelspitze 12 vorgesehen.

Die Ansteuerung der Nadelverfahreinrichtung 13 und der Spannungsquelle 14 erfolgt durch eine Steuereinrichtung 15, die dazu ausgestaltet ist, einen Musterschreibprozess mittels Steuersignalen ST1 und ST2 zu steuern, also die Nadelspitze 12 mit der Nadelverfahreinrichtung 13 in solche Bereiche oberhalb des Trägers 20 zu bewegen, an der eine Lokalisierung erfolgen soll, und in diesen Bereichen die zum Schreiben geeignete Spannung U mittels der Spannungsquelle 14 anzulegen. In Bereichen, in denen keine Lokalisierung der Moleküle M erfolgen soll, wird eine andere Spannung U, die keine Lokalisierung hervorruft, oder eine Spannung U von null Volt angelegt.

Besonders geeignete Moleküle M, mit denen sich das Musterschreibverfahren durchführen lässt, sind beispielsweise solche, die eine Ringstruktur aufweisen. In einem solchen Falle können sich alle zu der zweidimensionalen Monolagengasschicht MGS gehörenden beweglichen Moleküle M derart ausrichten, dass die Ringfläche ihrer Ringstruktur parallel zur Trägeroberfläche 21 und der Bewegungsebene der Monolagengasschicht MGS liegt. Durch das Anlegen einer geeigneten elektrischen Spannung U zwischen dem Träger 20 und der Nadelspitze 12 kann die Ringstruktur der im Bereich der Nadelspitze 12 befindlichen Moleküle M aus der Ebene der Monolagengasschicht MGS herausgedreht werden, beispielsweise um 90° in eine zur Oberfläche 21 senkrechte Lage, wodurch die Moleküle M auf dem Träger 20 immobilisiert und fixiert werden.

Das Musterschreibverfahren kann beispielsweise mit N-heterozyklischen Carben-(NHC)-Molekülen M durchgeführt werden, die auf einer Oberfläche 21 aus dotiertem (vorzugsweise Bor-dotiertem) Silizium oder GaAs lokalisiert werden.

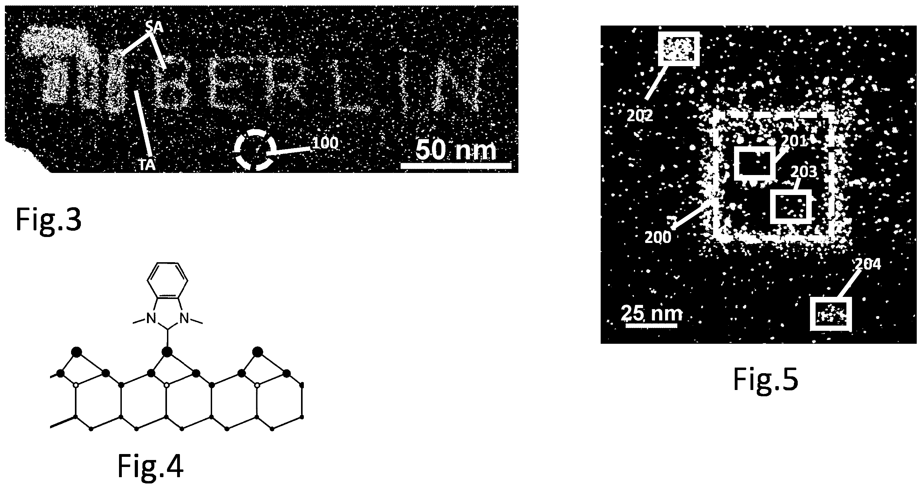

Eine geeignete elektrische Spannung U zwischen dem Träger 20 und der Nadelspitze 12 für das Lokalisieren der Moleküle M, also für das Schreiben von Schreibabschnitten SA (siehe Figur 3), ist eine positive Spannung U im Bereich zwischen +2 und +5 Volt.

Eine besonders geeignete elektrische Spannung U, bei der kein Lokalisieren der Moleküle M erfolgen soll, ist eine Spannung U von Null oder eine negative Spannung U. Die Steuereinrichtung 15 kann also in einfacher Weise durch das Umpolen der elektrischen Spannung U entscheiden, ob ein Schreibabschnitt SA (siehe Figur 3) mit lokalisierten Molekülen gebildet oder ein molekülfreier Trennabschnitt TA (siehe Figur 3) erhalten bleiben soll.

Bei der Anordnung 10 gemäß Figur 1 sind die Effusionszelle 11 und die Nadelspitze 12 innerhalb einer Prozesskammer 16 eines Rastertunnel- oder Rasterkraftmikroskops angeordnet.

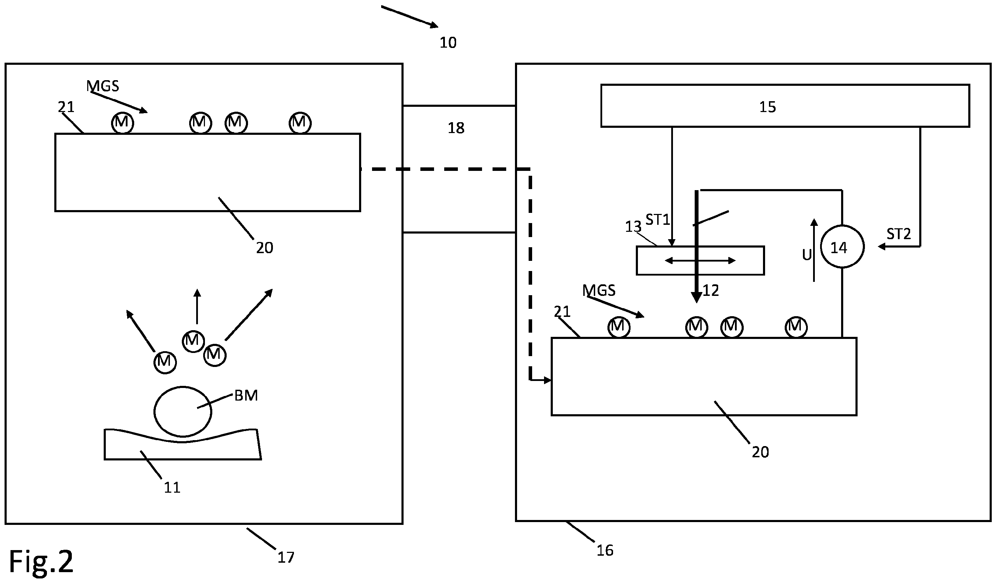

Die Figur 2 zeigt ein weiteres Ausführungsbeispiel einer für das beschriebene Musterschreibverfahren geeigneten Anordnung 10. Bei der Anordnung 10 gemäß Figur 2 ist die Effusionszelle 11 in einem Effusionsraum 17 unmittelbar neben einer Prozesskammer 16 eines Rastertunnel- oder Rasterkraftmikroskops angeordnet.

Bei der Anordnung 10 gemäß Figur 2 erfolgt das Erhitzen des Basismaterials BM in dem Effusionsraum 17 während einer ersten zeitlichen Prozessphase und wird mit Abschluss der ersten Prozessphase beendet. Während dieser ersten Prozessphase wird in dem Effusionsraum 17 eine dreidimensionale, die verdampften Moleküle M enthaltende Gasatmosphäre erzeugt, aus der heraus sich alle oder zumindest ein Teil der Moleküle M der Gasatmosphäre auf dem Träger 20 unter Bildung der Monolagengasschicht MGS abscheiden.

Nach Abschluss der ersten Prozessphase wird der Träger 20 in einer anschließenden zweiten Prozessphase gemeinsam mit der darauf befindlichen Monolagengasschicht MGS von dem Effusionsraum 17 in den ebenfalls unter Vakuumbedingungen befindlichen benachbarten Prozessraum 16, in dem sich die Nadelspitze 12 befindet, überführt und es wird das lokale Fixieren der Moleküle M der Monolagengasschicht MGS in dem benachbarten Prozessraum 16 durchgeführt, beispielsweise so, wie dies oben im Zusammenhang mit der Figur 1 erläutert worden ist.

Der Effusionsraum 17 kann von dem Prozessraum 16 durch einen Trennpfad 18 oder dergleichen getrennt sein, um das Beschichten des Trägers 20 mit der Monolagengasschicht MGS separat von dem nachfolgenden Lokalisieren durchführen zu können und den Prozessraum 16 von ungewollten Ablagerungen von Basismaterial BM zu schützen; in einem solchen Falle bleibt der Trennpfad 18 in der ersten Prozessphase geschlossen und wird nur für den Transport des mit der Monolagengasschicht MGS beschichteten Trägers 20 in den Prozessraum 16 geöffnet.

Bei beiden oben im Zusammenhang mit den Figuren 1 bis 2 beschriebenen Verfahren führen die verwendeten kleinen Spannungen (um 2-5 V) zu einer nur kleinen Wechselwirkung mit der Oberfläche 21 des Trägers 20, wodurch die Methode zerstörungsfrei oder zumindest sehr zerstörungsarm ist.

In ersten Versuchen konnten Schreibgeschwindigkeiten im Bereich von bis zu 5 µm/s realisiert werden. Die Genauigkeit liegt mit minimalen Linienbreiten von ca. 2 nm im Bereich der lateralen Abmessungen der Moleküle M.

Wie bereits erwähnt, gehören die im oben beschriebenen Verfahren genutzten organischen Molekülen vorzugsweise zur Klasse der N-heterozyklischen Carbene (NHC), welche in den letzten Jahren für großes Aufsehen gesorgt haben. Sie bestehen aus einem heterozyklischen Ring aus C und N Atomen, von denen eines, das sogenannte Carben-C-Atom, zwei unabgesättigte Elektronen aufweist. NHC zeichnen sich durch eine hohe Modifizierbarkeit, z. B. durch unterschiedliche Seitengruppen an den N-Atomen oder im Rückgrat, aus. Mit dem oben beschriebenen Verfahren ist es nunmehr möglich, hochgeordnete NHC-Monolagen auf Oberflächen mit einem gewünschten Muster, also mit Schreibabschnitten SA (siehe Figur 3), in denen die Moleküle M lokalisiert sind, und Trennabschnitten TA (siehe Figur 3) zwischen solchen Schreibabschnitten SA herzustellen.

Beispielsweise besteht die Möglichkeit, gezielt Molekülmonolagen mittels eines Rastertunnelmikroskops zu schreiben, wobei die Moleküle M vorher als Monolagengasschicht MGS auf der Oberfläche 21 aufgebracht worden sind. Mit dem Rastertunnelmikroskop wird eine metallische Spitze sehr nahe an eine leitende oder halbleitende Probenoberfläche gebracht. Bei genügend kleinen Abständen können Elektronen aufgrund des quantenmechanischen Tunneleffekts zwischen Spitze und Probe wechseln und bei Anlegen einer Spannung U fließt ein messbarer Tunnelstrom im pA- bis nA-Bereich. Dieser wird genutzt, um durch Abrastern der Oberfläche 21 ein Abbild dieser zu erhalten. Die Richtung des Tunnelns ist dabei abhängig von der Polarität der Spannung U: Bei positiver Probenspannung tunneln die Elektronen aus der Spitze in unbesetzte elektronische Probenzustände, bei negativer Probenspannung umgekehrt.

Bei einem Rastertunnelmikroskopie-basierten Musterschreibverfahren ist es also möglich, bei einer negativen Probenspannung stabil Rastertunnelmikroskopie-Bilder aufzunehmen, ohne dass eine nennenswerte Manipulation der Moleküle M auf der Oberfläche 21 stattfindet. Die Moleküle M, welche mobil auf der Oberfläche 21 vorhanden sind, bewegen sich zu schnell, um mit dem vergleichsweise langsamen Rastertunnelmikroskopie-Verfahren sichtbar zu sein. Wird hingegen eine positive Probenspannung im Bereich von 2-5 V angelegt, so werden die beweglichen Moleküle M unterhalb der Spitze immobilisiert und es entsteht ein Abbild der gerasterten Struktur. So wurde beispielsweise erfinderseitig der in der Figur 3 gezeigte "TU Berlin" Schriftzug generiert.

Das beschriebene Musterschreibverfahren wird vorzugsweise unter Ultrahochvakuumbedingungen und bei Raumtemperatur durchgeführt.

Beispielsweise können als NHC-Moleküle BIMe (1,3-Dimethylben-zimidazol-2-yliden) eingesetzt werden. Durch die hohe

Reaktivität sind solche NHC-Moleküle im Allgemeinen schwer handhabbar und das Carben-C-Atom wird daher vorzugsweise abgesättigt. Zur Vakuumverdampfung von NHC haben sich sogenannte CO₂- und H₂CO₃-Addukte als gute Ausgangsstoffe erwiesen. Vorteilhaft ist es, wenn BIMe-H₂CO₃ zum Einsatz kommt, welches in Pulverform vorliegt und in einen Verdampfer gefüllt wird. Wird das BIMe-H₂CO₃ Addukt im Verdampfer geheizt, entsteht unter Abspaltung von CO₂ und H₂O das freie NHC, welches auf der Oberfläche 21 deponiert werden kann. Als Substrat wird vorzugsweise eine mit Bor dotierte Siliziumoberfläche verwendet.

Im Rahmen von Testversuchen wurde erfinderseitig zum Schreiben der Moleküle M eine geringe Menge BIMe auf die Oberfläche 21 aufgebracht. Einzelne dieser Moleküle M können dabei - sozusagen als unerwünschter Schmutzeffekt - bereits vor dem Schreibprozess auf dem Träger 20 immobil sein; dies zeigen die hellen, zufällig verteilten Punkte 100 in der Figur 3. Aufgrund von Messungen der Höhe und lateralen Größe und Bestimmung des Adsorptionsplatzes kann davon ausgegangen werden, dass die immobilen Moleküle M an dem Träger 20 kovalent gebunden sind. Die Figur 4 zeigt beispielhaft die Struktur und Anordnung 10 eines auf einer Bor-dotierten Siliziumoberfläche befindlichen immobilen NHC-Moleküls.

Der nennenswerte Teil der Moleküle M ist allerdings, für das Rastertunnelmikroskop unsichtbar, auf dem Träger 20 mobil, und zwar als hochmobiles zweidimensionales Molekülgas (2D-Gas), welches die Moleküle M zum Schreiben bereitstellt.

Um diesen Sachverhalt nachzuweisen, wurde erfinderseitig das in Figur 5 gezeigte Experiment durchgeführt. Zunächst wurde ein in der Figur 5 mit weiß gestrichelter Linie markierter Rahmen 200 aus Molekülen auf die Oberfläche 21 geschrieben. Unter der Annahme, dass dieser eine Barriere für die sich auf der Oberfläche 21 bewegenden Moleküle M darstellt, sollte es innerhalb des Rahmens 200 nicht mehr möglich sein, weitere Muster zu schreiben. Genau dies ist auch der Fall, wie anhand der mit weiß durchgezogener Linie markierten Quadrate 201 bis 204 zu sehen ist, wo jeweils versucht wurde, die Oberfläche 21 zu beschreiben. Innerhalb des Rahmens 200 (siehe Quadrate 201 und 203) funktioniert das nicht, während außerhalb (siehe Quadrate 202 und 204) des Rahmens 200 geschrieben werden konnte. Dieser Versuch zeigt eindeutig, dass die Moleküle M von den umgebenden Bereichen der Oberfläche 21 bereitgestellt werden und nicht beispielsweise aus dem Vakuum oder von der Tunnelspitze abgelagert werden.

Die mit dem beschriebenen Musterschreibverfahren "geschriebenen" Moleküle M weisen das gleiche Erscheinungsbild (Höhe, laterale Abmessungen, Adsorptionsplatz) auf, wie die oben diskutierten, bereits nach dem Aufdampfen (unerwünscht) vorhandenen stabilen BIMe-Moleküle 100 (siehe Figur 3). Daraus kann geschlossen werden, dass sie dieselbe aufrechte Adsorptionsgeometrie mit Bindung an die Si-Substratadatome aufweisen. Es lassen sich somit gezielt lokalisierte NHC-Monolagen auf die Oberfläche 21 aufbringen. Wie auch beim direkten Wachstum von NHC-Monolagen auf Bor-dotiertem Silizium bilden sich keine Mehrfachlagen. Die direkt gewachsenen NHC-Monolagen zeichnen sich durch eine hohe thermische Stabilität aus und führen zu starken Änderungen der Austrittsarbeit [3]. Es kann also davon ausgegangen werden, dass die durch das hier beschriebene Verfahren hergestellten Monolagen mit Muster dieselben Eigenschaften aufweisen wie ganzflächige Monolagen ohne Muster.

Weiterhin wurde beobachtet, dass die Monolagengasschicht (MGS) nach einiger Zeit (ca. 2-3 Tage) verschwunden ist und dann ebenfalls kein Schreiben mehr möglich ist. Das wiederholte Aufbringen einer kleinen Menge BIMe führt zur Wiederherstellung der Schreibfähigkeit. Es findet somit mit der Zeit auch eine (vermutlich thermisch angeregte) Immobilisierung oder Desorption der Moleküle M der Monolagengasschicht (MGS) statt.

Die hohe Modifizier- und Funktionalisierbarkeit von NHC-Molekülen machen das beschriebene Verfahren sehr interessant, da die mit der Zeit selbständige Immobilisierung der Moleküle es möglich machen kann, Muster aus verschiedenen NHC-Molekülen, welche beispielsweise unterschiedliche Funktionalisierungen oder Ätzresistenzen aufweisen, zu erstellen. Dabei würde zunächst eine erste Molekülsorte aufgedampft und die Oberfläche 21 entsprechend modifiziert werden. Wenn sich die Monolagengasschicht (MGS) stabilisiert hat, kann dann eine andere Molekülsorte aufgebracht werden und es können mit dieser anderen Molekülsorte weitere Muster geschrieben werden.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

### Literaturliste

[1] Garcia, R. et al., Advanced scanning probe lithography, Nat. Nanotechnol. 9, 577 (2014).
[2] Fan, P. et al., Scanning Probe Lithography: State-of-the-Art and Future Perspectives, Micromachines 13, 228 (2022).
[3] Franz, M. et al., Controlled growth of ordered monolayers of N-heterocyclic carbenes on silicon, Nat. Chem. 13, 828 (2021).

## Patentansprüche

1. Verfahren zum lokalisierten Aufbringen von Molekülen (M) auf einem Träger (20), bei dem
unter Vakuumbedingungen auf dem Träger (20) eine die Moleküle (M) enthaltende, zweidimensionale Monolagengasschicht (MGS) gebildet wird, in der sich die zu der zweidimensionalen Monolagengasschicht (MGS) gehörenden Moleküle (M) parallel zur Oberfläche (21) des Trägers (20) bewegen können, und
durch Anlegen einer elektrischen Spannung (U) zwischen dem Träger (20) und einer unmittelbar oberhalb des Trägers (20) und mit der zweidimensionalen Monolagengasschicht (MGS) interagierenden Nadelspitze (12) die in der Nähe der Nadelspitze (12) befindlichen Moleküle (M) der zweidimensionalen Monolagengasschicht (MGS) auf dem Träger (20) gezielt dauerhaft lokalisiert werden.

2. Verfahren nach Anspruch 1,
**dadurch gekennzeichnet, dass**
ein Musterschreibprozess durchgeführt wird, bei dem auf dem Träger (20) ein Muster mit lokalisierten Molekülen (M) geschrieben wird, wobei die Polarität der Spannung (U) zwischen Träger (20) und Nadelspitze (12) während des Musterschreibprozesses invertiert wird.

3. Verfahren nach einem der voranstehenden Ansprüche,
**dadurch gekennzeichnet, dass**
ein Musterschreibprozess durchgeführt wird, bei dem ein Muster mit zumindest zwei voneinander durch einen Trennabschnitt getrennten Schreibabschnitten mit lokalisierten Molekülen geschrieben wird, indem in den Schreibabschnitten die Nadelspitze (12) mit einer ersten Spannungspolarität über den Träger geführt wird und im Trennbereich zwischen den Schreibabschnitten die Nadelspitze (12) mit einer zweiten Spannungspolarität über den Träger geführt wird.

4. Verfahren nach einem der voranstehenden Ansprüche,
**dadurch gekennzeichnet, dass**
zwei oder mehr Musterschreibprozesse durchgeführt werden, wobei im Rahmen eines ersten Musterschreibprozesses ein zumindest einen Schreibabschnitt aufweisendes erstes Molekülmonolagenmuster mit einer ersten Molekülart geschrieben wird und im Rahmen eines zweiten oder folgenden Musterschreibprozesses ein zumindest einen Schreibabschnitt aufweisendes zweites oder folgendes Molekülmonolagenmuster mit einer zweiten Molekülart oder weiterer Molekülarten geschrieben wird, wobei der oder die Schreibabschnitte des ersten Molekülmonolagenmusters mit dem oder den Schreibabschnitten der weiteren Molekülmonolagenmuster überschneidungsfrei sind.

5. Verfahren nach einem der voranstehenden Ansprüche,
**dadurch gekennzeichnet, dass**
die Spannung (U) zwischen Träger (20) und Nadelspitze (12) bei der ersten Spannungspolarität eine positive Spannung (U), bei der das elektrische Potential an dem Träger (20) höher als das elektrische Potential an der Nadelspitze (12) ist, und bei der zweiten Spannungspolarität eine negative Spannung (U), bei der das elektrische Potential an dem Träger (20) kleiner als das elektrische Potential an der Nadelspitze (12) ist.

6. Verfahren nach einem der voranstehenden Ansprüche,
**dadurch gekennzeichnet, dass**
die Spannung (U) zwischen Träger (20) und Nadelspitze (12) beim Schreiben der Schreibabschnitte zwischen 2 und 5 Volt liegt.

7. Verfahren nach einem der voranstehenden Ansprüche,
**dadurch gekennzeichnet, dass**
sich die Moleküle (M) mit dem Träger (20) unter Bildung der zweidimensionalen Monolagengasschicht (MGS) koppeln und die zweidimensionale Monolagengasschicht (MGS) auf der Oberfläche (21) des Trägers (20) durch eine durch die gekoppelten Moleküle (M) bewirkte Haltekraft gehalten wird,
wobei jedes der zu der zweidimensionalen Monolagengasschicht (MGS) gehörenden Moleküle (M) zu jedem Zeitpunkt jeweils mit mindestens einem Trägeratom an der Oberfläche (21) des Trägers (20) kraftmäßig gekoppelt ist.

8. Verfahren nach einem der voranstehenden Ansprüche,
**dadurch gekennzeichnet, dass**
die Moleküle (M) eine Ringstruktur aufweisen,
alle zu der zweidimensionalen Monolagengasschicht (MGS) gehörenden beweglichen Moleküle (M) derart ausgerichtet sind, dass die Ringfläche ihrer Ringstruktur parallel zur Oberfläche (21) des Trägers (20) und der Bewegungsebene der Monolagengasschicht (MGS) liegt, und
durch das Anlegen der elektrischen Spannung (U) zwischen dem Träger (20) und der Nadelspitze (12) die Ringstruktur der im Bereich der Nadelspitze (12) befindlichen Moleküle (M) aus der Ebene der Monolagengasschicht (MGS) herausgedreht und dadurch auf dem Träger (20) immobilisiert und fixiert wird.

9. Verfahren nach einem der voranstehenden Ansprüche,
**dadurch gekennzeichnet, dass**
die Moleküle (M) durch Erhitzen eines die Moleküle (M) enthaltenen Basismaterials (BM) bereitgestellt werden, wobei das Erhitzen des Basismaterials (BM) in einem Effusionsraum (17) während einer ersten zeitlichen Prozessphase erfolgt und mit Abschluss der ersten Prozessphase beendet wird, und
wobei während dieser ersten Prozessphase in dem Effusionsraum (17) eine dreidimensionale, die verdampften Moleküle (M) enthaltende Gasatmosphäre erzeugt wird, aus der heraus sich alle oder zumindest ein Teil der Moleküle (M) der Gasatmosphäre auf dem Träger (20) unter Bildung der Monolagengasschicht (MGS) abscheiden,
nach Abschluss der ersten Prozessphase der Träger (20) in einer anschließenden zweiten Prozessphase gemeinsam mit der darauf befindlichen Monolagengasschicht (MGS) von dem Effusionsraum (17) in einen ebenfalls unter Vakuumbedingungen befindlichen benachbarten Prozessraum (16), in dem sich die Nadelspitze (12) befindet, überführt wird und das lokale Fixieren der Moleküle (M) der Monolagengasschicht (MGS) in dem benachbarten Prozessraum (16) durchgeführt wird, und
in der zweiten Prozessphase durch das Anlegen der elektrischen Spannung (U) zwischen dem Träger (20) und der Nadelspitze (12) in dem benachbarten Prozessraum (16) die in der Nähe der Nadelspitze (12) befindlichen Moleküle (M) der zweidimensionalen Monolagengasschicht (MGS) auf dem Träger (20) dauerhaft lokalisiert werden.

10. Verfahren nach einem der voranstehenden Ansprüche 1 bis 8,
**dadurch gekennzeichnet, dass**
das lokale Fixieren der Moleküle (M) der Monolagengasschicht (MGS) in demselben Prozessraum (16) durchgeführt wird, in dem auch die Moleküle (M) in Form der Monolagengasschicht (MGS) auf dem Träger (20) abgeschieden worden sind,
wobei während des Erhitzens des Basismaterials (BM) in dem Prozessraum (16) eine dreidimensionale, die verdampften Moleküle (M) enthaltende Gasatmosphäre erzeugt wird, aus der heraus sich alle oder zumindest ein Teil der Moleküle (M) der Gasatmosphäre auf dem Träger (20) unter Bildung der Monolagengasschicht (MGS) abscheiden, und
wobei bereits während des Erhitzens oder nach dem Erhitzen durch das Anlegen der elektrischen Spannung (U) zwischen dem Träger (20) und der Nadelspitze (12) die in der Nähe der Nadelspitze (12) befindlichen Moleküle (M) der zweidimensionalen Monolagengasschicht (MGS) auf dem Träger (20) dauerhaft lokalisiert werden.

11. Verfahren nach einem der voranstehenden Ansprüche,
**dadurch gekennzeichnet, dass**
die mit der zweidimensionalen Monolagengasschicht (MGS) interagierende Nadelspitze (12) ein Bestandteil eines Rastertunnelmikroskops ist.

12. Verfahren nach einem der voranstehenden Ansprüche, **dadurch gekennzeichnet, dass**
die Moleküle (M) N-heterozyklische Carben-Moleküle sind.

13. Anordnung zum Aufbringen von Molekülen (M) auf einem Träger (20),
mit
einer Effusionszelle (11) zum Erhitzen eines die Moleküle (M) enthaltenden Basismaterials (BM) unter Vakuumbedingungen und Bilden einer die Moleküle (M) enthaltenden, zweidimensionalen Monolagengasschicht (MGS) auf dem Träger (20), in der sich die zu der zweidimensionalen Monolagengasschicht (MGS) gehörenden Moleküle (M) parallel zur Oberfläche (21) des Trägers (20) bewegen können,
einer unmittelbar oberhalb des Trägers (20) befindlichen und mit der zweidimensionalen Monolagengasschicht (MGS) interagierenden Nadelspitze (12),
einer Spannungsquelle (14) zum Anlegen einer elektrischen Spannung (U) zwischen dem Träger (20) und der Nadelspitze (12),
einer Nadelverstelleinrichtung (13) und
einer Steuereinrichtung (15), die dazu ausgestaltet ist, einen Musterschreibprozess zu steuern, und zwar durch Ansteuern der Nadelverstelleinrichtung (13) und der Spannungsquelle (14) und einem lokalen Hervorrufen einer Schreibspannung, die zum gezielten dauerhaften Lokalisieren der in der Nähe der Nadelspitze (12) befindlichen Moleküle (M) der zweidimensionalen Monolagengasschicht (MGS) auf dem Träger (20) führt.

14. Anordnung nach Anspruch 13,
**dadurch gekennzeichnet, dass**
die Effusionszelle (11) und die Nadelspitze (12) innerhalb derselben Prozesskammer (16) eines Rastertunnel- oder Rasterkraftmikroskops angeordnet sind oder
die Effusionszelle (11) in einer Effusionskammer (17) neben einer Prozesskammer (16) eines Rastertunnel- oder Rasterkraftmikroskops angeordnet ist, wobei der mit der zweidimensionalen Monolagengasschicht (MGS) beschichtete Träger (20) unter Vakuumbedingungen von der Effusionskammer (17) in die die Nadelspitze (12) enthaltende Prozesskammer (16) überführt werden kann.
